Europäisches Patentamt

European Patent Office

Office européen des brevets

(19)

(11) Numéro de publication : **0 438 363 B1**

# (12) FASCICULE DE BREVET EUROPEEN

(45) Date de publication du fascicule du brevet :
**16.03.94 Bulletin 94/11**

(51) Int. Cl.$^5$ : **G01R 31/26**

(21) Numéro de dépôt : **91420005.0**

(22) Date de dépôt : **07.01.91**

(54) **Circuit de mesure du courant dans un transistor MOS de puissance.**

(30) Priorité : **09.01.90 FR 9000401**

(43) Date de publication de la demande :
**24.07.91 Bulletin 91/30**

(45) Mention de la délivrance du brevet :
**16.03.94 Bulletin 94/11**

(84) Etats contractants désignés :
**DE ES FR GB IT**

(56) Documents cités :
**EP-A- 0 249 325**
**E.D.N. ELECTRICAL DESIGN NEWS, vol. 31,**
**no. 18, septembre 1986, pges 193-198,200,**
**Newton, MA, US; G. FAY: "Current-mirror**
**FETs cut costs and sensing losses"**
**E.D.N. ELECTRICAL DESIGN NEWS, vol. 31,**
**no. 13, 26 juin 1986, pages 169-174,176,178,**
**Newton, MA, US; W. SCHULTZ: "Sense-cell**
**MOSFET eliminates losses in source circuit"**

(73) Titulaire : **SGS-THOMSON**
**MICROELECTRONICS s.r.l.**
**Via C. Olivetti, 2**
**I-20041 Agrate Brianza Milano (IT)**
Titulaire : **SIEMENS AUTOMOTIVE S.A.**
**Avenue du Mirail - B.P. 1149**
**F-31036 Toulouse Cédex (FR)**

(72) Inventeur : **Cini, Carlo**
**c/o Lab. Ricerca & Sviluppo, Casella Postale,**
**176**
**I-20010 Cornaredo (MI) (IT)**
Inventeur : **Rossi, Domenico**
**c/o Lab. Ricerca & Sviluppo, Casella Postale,**
**176**
**I-20010 Cornaredo (MI) (IT)**
Inventeur : **Simon, Marc**
**210 bis, Chemin du Ramelet-Moundi**
**F-31170 Tournefeuille (FR)**

(74) Mandataire : **de Beaumont, Michel**
**1bis, rue Champollion**
**F-38000 Grenoble (FR)**

EP 0 438 363 B1

## Description

La présente invention concerne la mesure du courant dans un transistor de puissance, et plus particulièrement dans un transistor MOS de puissance, constitué d'une pluralité de cellules élémentaires disposées en parallèle.

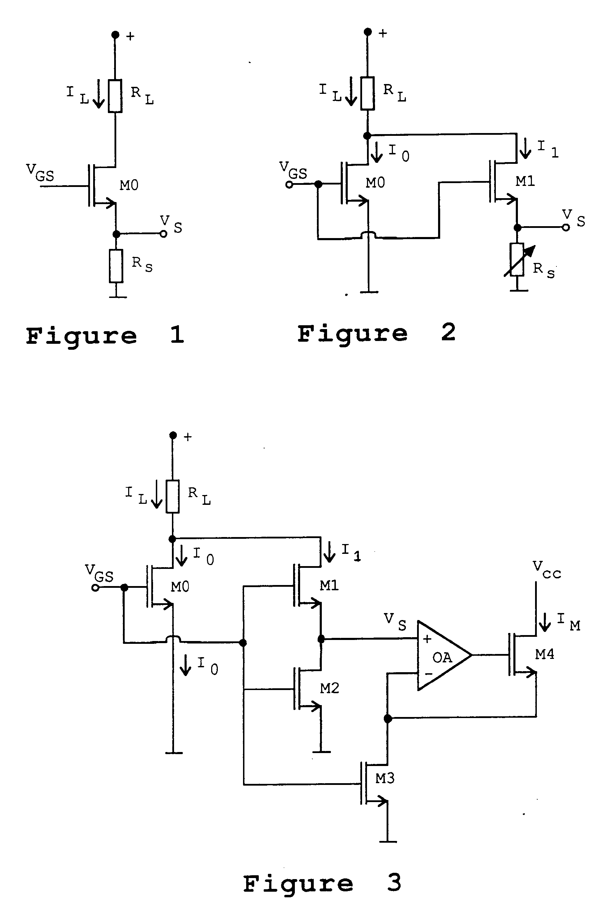

La figure 1 représente l'un des montages les plus classiques de mesure du courant dans un transistor de puissance M0. Ce montage consiste à disposer entre la borne du transistor de puissance reliée à la tension de référence (la source) et cette tension de référence une résistance de mesure $R_S$. L'autre borne du transistor de puissance est connectée à une tension haute par l'intermédiaire d'une charge $R_L$ dans laquelle circule un courant $I_L$, identique en ce cas au courant dans le transistor de puissance. La mesure de la tension $V_S$ aux bornes de la résistance $R_S$ fournit une indication de la valeur du courant.

Ce montage présente plusieurs inconvénients.

Le premier inconvénient est est que la résistance $R_S$ se trouve en permanence en série avec le transistor MOS de puissance et entraîne une augmentation de la puissance dissipée qui n'est pas absolument négligeable puisque la résistance $R_S$ doit avoir une valeur suffisante pour que la tension à ses bornes soit détectable.

Un autre inconvénient de ce montage est que la résistance $R_S$ est susceptible de varier avec la température ou d'un lot de fabrication à un autre d'une façon qui diffère des variations éventuelles des caractéristiques du transistor MOS de puissance. Il en résulte une mauvaise détermination de sa valeur et donc du courant que l'on mesure.

Pour éliminer le premier inconvénient susmentionné, on a eu recours dans l'art antérieur à des montages tels que celui de la figure 2. Dans cette figure, on retrouve le transistor MOS de puissance M0. La borne supérieure (drain) du transistor M0 est reliée à une borne d'alimentation positive à travers la charge $R_L$ dont on veut commander l'alimentation. Le montage en série d'un transistor M1 et d'une résistance $R_S$ est placé en parallèle sur le transistor de puissance M0, les grilles des transistors M0 et M1 étant interconnectées au potentiel $V_{GS}$. Il est clair que le premier inconvénient est résolu, mais que le deuxième inconvénient à savoir les fluctuations éventuelles de la résistance $R_S$ indépendantes des fluctuations des autres éléments du circuit subsiste.

Ainsi, la présente invention prévoit un procédé de mesure de courant dans un transistor de puissance permettant de s'abstraire des variations éventuelles résultant de la température ou du processus de fabrication entre des caractéristiques de résistance et de transistor MOS.

Pour atteindre cet objet ainsi que d'autres, la présente invention prévoit un circuit de mesure du courant circulant dans un transistor MOS de puissance, comprenant des deuxième et troisième transistors MOS de même type et de même technologie mais de plus petite surface que le transistor de puisssance, lesdits deuxième et troisième transistors MOS ayant leurs canaux connectés en série et ladite connection en série étant disposée en parallèle sur le canal du transistor de puissance, ces deux transistors en série ayant leurs grilles connectées à la grille du transistor de puissance, et des moyens de mesure du courant circulant dans le troisième transistor qui est relié à l'électrode du transistor de puissance qui est connectée à la tension de référence.

Selon un mode de réalisation de la présente invention, les moyens de courant comprenant un quatrième transistor MOS monté en miroir de courant avec le troisième.

Selon un mode de réalisation de la présente invention, le drain du troisième transistor MOS est connecté à l'entrée non-inverseuse d'un amplificateur opérationnel dont l'entrée inverseuse est reliée au drain du quatrième transistor MOS dont la grille est connectée à la grille du troisième transistor MOS, la sortie de l'amplificateur opérationnel étant connectée à la grille d'un cinquième transistor dont le canal est connecté en série avec le canal du quatrième transistor MOS aux borne d'une source d'alimentation, la source du quatrième transistor MOS étant reliée au potentiel de référence.

Ces objets, caractéristiques et avantages ainsi que d'autres de la présente invention seront exposés plus en détail dans la description suivante d'un mode de réalisation particulier faite en relation avec les figures jointes parmi lesquelles:

les figures 1 et 2 décrites précédemment étaient destinées à illustrer l'état de la technique; et

la figure 3 représente schématiquement un montage selon la présente invention.

Dans ces diverses figures 3, de mêmes références désignent des éléments identiques ou analogues.

Dans le montage de la figure 3, deux transistors M1 et M2 sont disposés en série l'un avec l'autre et en parallèle sur le transistor M0. Les grilles des transistors M0, M1 et M2 sont interconnectées. Les drains des transistors M0 et M1 sont reliés ainsi que les sources des transistors M0 et M2 qui sont au potentiel de référence, par exemple la masse.

Les transistors M1 et M2 sont du même type que le transistor de puissance M0. Si le transistor M0 est un transistor de puissance du type DMOS multicellule, les transistors M1 et M2 seront constitués d'un petit nombre de cellules identiques aux cellules constituant le transistor M0. Dans un exemple pratique, le transistor M0 pourra comprendre 3600 cellules, le transistor M1 7 cellules et le transistor M2 14 cellules.

Si l'on considère que la tension $V_{GS}$ est suffisamment élevée pour que chacun des transistors fonctionne dans sa région linéaire, tous ces transistors auraient des résistances à l'état passant strictement

2

proportionnelles au nombre de cellules qui les constituent si leurs tensions grille/source étaient identiques. En fait, on notera que la tension grille/source du transistor M1 est légèrement plus faible que la tension grille/source des autres transistors puisque la source du transistor M1 est à un potentiel plus élevé que celui des autres transistors. En effet, la source du transistor M1, au lieu d'être reliée directement au potentiel de référence (la masse), est reliée à ce potentiel par l'intermédiaire du transistor M2. Ainsi, la tension grille/source du transistor M1 est en fait $V_{GS}$ (M0) moins la chute de tension drain/source aux bornes du transistor M2. Toutefois, cette chute de tension est en pratique seulement de l'ordre de quelques centaines de millivolts alors que la tension $V_{GS}$ sera choisie de l'ordre de 10 volts. On peut donc considérer que la proportionnalité entre les valeurs des résistances internes à l'état passant des transistors MOS et le nombre de cellules qui les constituent est en première approximation respectée. En tous cas, des simulations effectuées par les demandeurs ont montré que ce résultat était obtenu à mieux que 5 % et restait dans cette plage quelles que soient les variations de température et de technologie puisque les trois transistors M0, M1 et M2 varient de la même manière avec les variations de température et avec les dispersions de technologie.

On peut utiliser le montage décrit jusqu'ici pour détecter si la tension $V_S$ dépasse un seuil déterminé correspondant par exemple à un court-circuit dans la charge. On comparera alors simplement cette tension $V_S$ à une tension de référence à l'aide d'un comparateur.

On peut également utiliser ce montage pour effectuer une mesure de courant. Pour cela, on utilisera de préférence un circuit supplémentaire tel qu'apparaissant dans la partie droite de la figure 3 et comprenant un amplificateur opérationnel OA et des transistors MOS supplémentaires M3 et M4.

L'amplificateur OA reçoit sur son entrée non-inverseuse la tension à mesurer, à savoir la tension de drain du transistor M2. L'entrée inverseuse de l'amplificateur opérationnel OA est reliée à la tension de référence par l'intermédiaire d'un transistors MOS supplémentaire M3 de même type que les transistors M0, M1 et M2. La sortie de l'amplificateur OA est reliée à la grille d'un transistor MOS M4 dont le drain est relié à une tension d'alimentation VCC et dont la source est connectée à l'entrée inverseuse de l'amplificateur OA.

Avec ce montage la tension sur l'entrée inverseuse tend à devenir égale à la tension sur l'entrée non-inverseuse et donc le courant dans le transistor M3 (qui sera également le courant traversant le transistor M4) est égal au courant traversant le transistor M2 si ces deux transistors sont identiques. Ces courants sont proportionnels au nombre de cellules constituant ces transistors si ceux-ci sont distincts. Le courant de mesure $I_M$ traversant les transistors M4 et M3 est :

$$I_M/I0 = (R0/R3)(R2/R1 + R2),$$

où R0 à R3 désignent les résistances à l'état passant des transistors M0 à M3.

Ainsi, le rapport entre le courant de mesure et le courant dans le transistor de puissance, que l'on veut déterminer, ne dépend que du rapport de résistances à l'état passant de transistors constitués de cellules identiques. Ce rapport est donc constant et sensiblement égal au rapport du nombre de cellules constituant chaque transistor.

Bien entendu, la présente invention est susceptible de diverses variantes et modifications qui apparaîtront à l'homme de l'art. Notamment le cuircuit selon l'invention pourra être combiné avec d'autres circuits classiques, par exemple des circuits destinés à annuler le décalage de tension au zéro (offset) de l'amplificateur opérationnel OA.

## Revendications

1. Circuit de mesure du courant circulant dans un transistor MOS de puissance (M0), caractérisé en ce qu'il comprend :

   des deuxièmes (M1) et troisième (M2) transistors MOS de même type et de même technologie mais de plus petite surface que le transistor de puissance (M0), lesdits deuxième (M1) et troisième (M2) transistors MOS ayant leurs canaux connectés en série et ladite connection en série étant disposée en parallèle sur le canal du transistor de puissance (M0), ces deux transistors en série ayant leurs grilles connectées à la grille du transistor de puissance (M0), et

   des moyens de mesure du courant circulant dans le troisième transistor (M2) qui est relié à l'électrode du transistor de puissance (M0) qui est connectée à la tension de référence.

2. Circuit de mesure de courant selon la revendication 1, caractérisé en ce que les moyens de mesure de courant comprennent un quatrième transistor MOS (M3) mis en relation de miroir de courant avec ledit troisième transistor MOS (M2).

3. Circuit de mesure de courant selon la revendication 2, caractérisé en ce que le drain du troisième transistor MOS (M2) est connecté à l'entrée non-inverseuse d'un amplificateur opérationnel (OA) dont l'entrée inverseuse est reliée au drain du quatrième transistor MOS (M3) dont la grille est connectée à la grille du troisième transistor MOS (M2), la sortie de l'amplificateur opérationnel étant connectée à la grille d'un cinquième transistor (M4) dont le canal est connecté en série avec le canal du quatrième transistor MOS (M3) aux bornes d'une source d'alimentation, la source du quatrième transistor MOS (M3) étant reliée au potentiel de référence.

## Patentansprüche

1. Schaltung zum Messen des in einem MOS-Leistungstransistor (MO) fließenden Stromes, gekennzeichnet durch:
   einen zweiten und einen dritten MOS-Transistor (M1, M2) gleichen Types und gleicher Technologie, jedoch mit einer gegenüber dem Leistungstransistor (MO) kleineren Oberfläche, wobei der zweite und dritte MOS-Transistor (M1, M2) mit ihren Kanälen in Serie geschaltet sind und diese Serienschaltung parallel zum Kanal des Leistungstransistors (MO) gelegen ist, und die Steuerelektroden dieser beiden in Serien geschalteten Transistoren mit der Steuerelektrode des Leistungstransistors verbunden sind, und
   eine Einrichtung zum Messen des in dem dritten Transistor (M2) fließenden Stromes, die mit der Elektrode des Leistungstransistors (MO) verbunden ist, die mit der Referenzspannung verbunden ist.

2. Strommeßschaltung nach Anspruch 1, dadurch gekennzeichnet, daß die Einrichtung zum Messen des Stromes einen vierten MOS-Transistor (M3) aufweist, der als Stromspiegel in bezug zu dem dritten MOS-Transistor (M2) ausgebildet ist.

3. Strommeßschaltung nach Anspruch 2, dadurch gekennzeichnet, daß die Drainelektrode des dritten MOS-Transistors (M2) mit dem nicht invertierenden Eingang eines Operationsverstärkers (OA) verbunden ist, dessen invertierender Eingang an die Drainelektrode des vierten MOS-Transistors (M3) angeschlossen ist, dessen Steuerelektrode mit der Steuerelektrode des dritten MOS-Transistors (M2) verbunden ist, wobei der Ausgang des Operationsverstärkers mit der Steuerelektrode eines fünften Transistors (M4) verbunden ist, dessen Kanal in Serie mit dem Kanal des vierten MOS-Transistors (M3) verbunden und an die Anschlüsse einer Versorgungsquelle angeschlossen ist und die Sourceelektrode des vierten MOS-Transistors (M3) an das Referenzpotential angeschlossen ist.

## Claims

1. A circuit for measuring the current flowing in a power MOS transistor (MO), characterized in that it comprises:
   second (M1) and third (M2) MOS transistors of the same type and same technology as, but having a smaller surface than, the power transistor (M0), said second (M1) and third (M2) MOS transistors having their channels connected in series and said serial connection being arranged in parallel with the channel of the MOS transistor (M0), said series transistors having their gates connected to the gate of the power transistor (M0), and
   means for measuring the current flowing in the third transistor (M2) which is connected to the electrode of the power transistor (M0) that is connected to the reference potential.

2. A circuit for measuring current according to claim 1, characterized in that said current measuring means comprise a fourth MOS transistor (M3) connected as a current mirror with said third MOS transistor (M2).

3. A circuit for measuring current according to claim 2, characterized in that the drain of the third MOS transistor (M2) is connected to the non-inverting input of an operational amplifier (OA), the inverting input of which is connected to the drain of the fourth MOS transistor (M3), whose gate is connected to the gate of the third MOS transistor, the output of the operational amplifier being connected to the gate of a fifth transistor (M4) having its channel connected in series with the channel of the fourth MOS transistor (M3) across the terminals of a supply source, the source of the fourth MOS transistor (M3) being connected to the reference potential.

Figure 1

Figure 2

Figure 3